# EUROPEAN PATENT APPLICATION

(11) **EP 4 782 740 A1**
(43) Date of publication of application: **29.07.2026**
(21) Application number: 24884539.8
(22) Date of filing: 23.10.2024
(51) Int. Cl.: F17D 1/04, F17D 3/01, F17D 3/18, F17D 5/00

(54) **GAS INTAKE CONTROL METHOD, GAS SUPPLY SYSTEM AND SEMICONDUCTOR PROCESS DEVICE**

(30) Priority: 31.10.2023 CN 202311435070
(71) Applicant: Beijing NAURA Microelectronics Equipment Co., Ltd., Beijing 100176 (CN)
(72) Inventor: TONG, Xin, Beijing 100176 (CN); LIU, He, Beijing 100176 (CN); ZHANG, Xinyi, Beijing 100176 (CN); DAI, Chaoxing, Beijing 100176 (CN)
(74) Representative: Cohausz & Florack
(86) International application number: PCT/CN2024/126705
(87) International publication number: WO 2025/092535

(57) **Abstract**

The present disclosure discloses a gas inlet control method, a gas supply system, and semiconductor process equipment, relating to the field of semiconductor process technology, to solve the problem of long switching times during gas changes. The gas inlet control method, applied to semiconductor process equipment, includes: obtaining a gas-regulating duration; controlling a first switching valve to remain closed and controlling a second switching valve to close; the first switching valve being connected between a mass flow meter and the gas supply pipeline of the process chamber; the second switching valve being connected between the mass flow meter and a vacuum pump; after the gas-regulating duration has elapsed, controlling the first switching valve to open and controlling the second switching valve to remain closed. The gas inlet control method provided by the present disclosure can shorten the switching time between different gas species.

## Description

### TECHNICAL FIELD

The present disclosure generally relates to the field of semiconductor process technology and, more particularly, to a gas inlet control method, a gas supply system, and semiconductor process equipment.

### BACKGROUND

With the rapid development of the semiconductor industry, finer atomic layer etching and deposition have been introduced into process technologies. At the same time, advanced packaging technologies such as TSV (Through Silicon Via) are also becoming widely used. These semiconductor process technologies need rapid switching between multiple mixed gas species. For example, the Bosch process in deep silicon etching includes a rapid switching between an etching process dominated by a fluorine-based gas and a deposition process dominated by a fluorocarbon gas. However, in related technologies, the gas switching time is long and the switching frequency is low, resulting in a scalloped sidewall morphology, thereby adversely affecting product yield.

### SUMMARY

The first objective of the present disclosure is to provide a gas inlet control method to solve the technical problem of long switching times.

To address the above technical problem, the present disclosure provides a gas inlet control method applied to semiconductor process equipment, including:
obtaining a gas-regulating duration;
controlling a first switching valve to remain closed and controlling a second switching valve to close, the first switching valve being connected between a mass flow meter and a gas supply pipeline of the process chamber, and the second switching valve being connected between the mass flow meter and a vacuum pump;
after the gas-regulating duration has elapsed, controlling the first switching valve to open and controlling the second switching valve to remain closed.

The beneficial effects of this gas inlet control method are:
by keeping both the first switching valve and the second switching valve closed, gas is supplied to the gas supply pipeline between the mass flow meter and the first switching valve and the second switching valve using the mass flow meter, causing the gas pressure in this area to rise. Furthermore, after the gas-regulating duration has elapsed, opening the first switching valve allows for rapid gas supply to the process chamber due to the higher gas pressure in this area, achieving rapid gas switching and improving process performance.

In some embodiments, obtaining the gas-regulating duration includes:
obtaining the volume and set flow rate of the gas-regulating pipeline;
obtaining the gas-regulating duration based on the volume and set flow rate of the gas-regulating pipeline.

In some embodiments, obtaining the gas-regulating duration further includes:
obtaining the gas-regulating pressure and the standard gas pressure;
obtaining the gas-regulating duration based on the gas-regulating pressure, the standard gas pressure, the volume and set flow rate of the gas-regulating pipeline. The gas-regulating duration is positively correlated with the gas-regulating pressure and negatively correlated with the standard gas pressure.

In some embodiments, the gas inlet control method further includes:
obtaining an actual gas pressure; if the actual gas pressure is greater than a preset gas pressure, controlling the second switching valve to open.

In some embodiments, controlling the first switching valve to remain closed and controlling the second switching valve to close includes:
obtaining a moment when gas is introduced into the chamber;
obtaining the gas-regulating start time based on the moment gas is introduced into the chamber and the gas-regulating duration;
at the gas-regulating start time, controlling the first switching valve to remain closed and controlling the second switching valve to close.

In some embodiments, the semiconductor process equipment includes a first pipeline set and a second pipeline set. The first pipeline set provides a first gas for performing a deposition process; the second pipeline set provides a second gas for performing an etching process. The first pipeline set and the second pipeline set are respectively provided with the mass flow meter, the first switching valve, and the second switching valve.

Throughout the deposition process, the first switching valve connected to the first pipeline set is kept open, and the second switching valve connected to the first pipeline set is kept closed, to provide the first gas to the process chamber.

During the pre-gas-regulating duration of the deposition process, the first switching valve connected to the second pipeline set is kept closed, and the second switching valve connected to the second pipeline set is kept open, to disconnect the second pipeline set from the process chamber and to allow the second gas to flow to the vacuum pump.

At the gas-regulating start time of the deposition process, the second switching valve connected to the second pipeline set is controlled to be closed and remain closed until the gas-regulating duration ends.

In some embodiments, controlling the first switching valve to remain closed and controlling the second switching valve to close further includes:
obtaining a process duration of the deposition process preceding the etching process that needs gas-regulating;
obtaining the pre-gas-regulating duration based on the process duration and the gas-regulating duration. The pre-gas-regulating duration is positively correlated with the process duration and negatively correlated with the gas-regulating duration.

A second objective of the present disclosure is to provide a gas supply system to solve the technical problem of long switching times.

The gas supply system provided by the present disclosure is applied to semiconductor process equipment including a process chamber. The gas supply system is configured to execute the above-described gas inlet control method provided in the present disclosure. The gas supply system includes:
A gas supply path, each gas supply path is independently connected to the process chamber via a first switching valve;
A vacuum pump, each gas supply path is independently connected to the vacuum pump via a second switching valve;
a mass flow meter, the gas supply path being connected to the first switching valve and the second switching valve via the mass flow meter; and
a check valve control assembly preventing the gas pressure on the side of the mass flow meter facing the first switching valve and the second switching valve from being higher than the pressure on the side of the mass flow meter facing the gas supply path.

By providing a check valve control assembly, when the gas supply pipeline is gas-regulating, gas in the gas-regulating pipeline between the first switching valve and the second switching valve can be released if the gas-regulating pressure becomes excessive. This eliminates the risk of mass flow meter failure or even gas backflow due to excessively high gas pressure in the gas-regulating pipeline between the mass flow meter and the first switching valve and the second switching valve caused by prolonged gas-regulating duration.

In some embodiments, the check valve control assembly includes a vacuum gauge configured to measure the gas pressure in the pipeline between the mass flow meter and the first switching valve or between the mass flow meter and the second switching valve.

In some embodiments, the check valve control assembly further includes a one-way valve disposed between the vacuum pump and the mass flow meter; the one-way valve is configured to allow only unidirectional flow from the mass flow meter to the vacuum pump.

In some embodiments, the gas supply system further includes a controller including:
an obtaining module configured to obtain the gas-regulating duration;
a first control module configured to control a first switching valve to remain closed and controlling a second switching valve to close, the first switching valve being connected between a mass flow meter and the gas supply pipeline of the process chamber, and the second switching valve being connected between the mass flow meter and a vacuum pump; and
a second control module configured to control the first switching valve to open and the second switching valve to close after the gas-regulating duration has elapsed.

A third objective of the present disclosure is to provide the semiconductor process equipment to solve the technical problem of long gas switching times.

The semiconductor process equipment provided by the present disclosure includes the gas supply system described above.

By incorporating the above gas supply system into the semiconductor process equipment, the semiconductor process equipment correspondingly possesses all the advantages of the above gas supply system, which will not be elaborated further here.

### BRIEF DESCRIPTION OF THE DRAWINGS

To more clearly illustrate the technical solutions in the embodiments or background art of the present disclosure, the drawings used in the description of the embodiments or background art will be briefly introduced below. Obviously, the drawings described below are merely embodiments of the present disclosure. For those skilled in the art, other drawings can be obtained based on the provided drawings without inventive effort.
FIG. 1 is a schematic diagram of a process chamber in the semiconductor process equipment to which the gas inlet control method provided in an embodiment of the present disclosure is applied;
FIG. 2 is a schematic diagram of a gas supply system in the semiconductor process equipment to which the gas inlet control method provided in an embodiment of the present disclosure is applied;
FIG. 3 is a schematic diagram of a sub-supply gas path in the gas supply system of semiconductor process equipment to which the gas inlet control method provided in an embodiment of the present disclosure is applied;
FIG. 4 is a schematic flowchart of a gas inlet control method provided in an embodiment of the present disclosure;
FIG. 5 is a comparative schematic diagram of gas state switching in a related art 1 and an embodiment of the present disclosure;
FIG. 6 is a schematic flowchart of the control process of the first switching valve and the second switching valve in a related art and an embodiment of the present disclosure;
FIG. 7 is a comparative timing diagram of the gas flow rate from a certain edge gas inlet pipeline into the process chamber in a related art and an embodiment of the present disclosure;
FIG. 8 is a schematic diagram of the gas pressure change in the process chamber when gas is introduced into the process chamber from a certain edge gas inlet pipeline in a related art and an embodiment of the present disclosure;
FIG. 9 is a flowchart of a gas inlet control method provided in an embodiment of the present disclosure;
FIG. 10 is a schematic diagram of the structure of a controller in a gas supply system in an embodiment of the present disclosure.

### Reference numerals:

101-Central gas inlet; 102-Edge gas inlet; 103-Molecular pump; 104-Vacuum Pump;
110-First pipeline set; 111-First branch line; 112-Second branch line; 113-Third branch line; 120-Second pipeline set;
131-First switching valve; 132-Second switching valve; 133-Mass flow meter; 134-Vacuum gauge;
401-Acquisition module; 402-First control module; 403-Second control module; 404-Pressure relief module.

### DETAILED DESCRIPTION OF THE EMBODIMENTS

### Related Technology 1:

This related technology provides a gas switching system for supplying different gas species to a chamber (such as the plasma process chamber of a plasma process equipment). The chamber may include multiple zones, and the gas distribution system can distribute different gas species to multiple zones. The gas switching system can selectively supply one or more gas species to the chamber, while the remaining gas species are supplied to bypass lines.

However, in this technology, the gas inlet flow rate is limited by the set flow rate of the MFC (mass flow controller), which may not be suitable for applications with large gas inlet flow rates. Furthermore, gas not introduced into the chamber is pumped away from the bypass line, resulting in gas waste.

### Related Technology 2:

This related technology discloses a plasma reaction chamber and method for achieving rapid switching of reaction gas species. It simultaneously injects two sets of gas species into the reaction chamber from the top and bottom, effectively reducing the chamber volume while ensuring that the substrate etching and deposition reactions are not affected. This facilitates faster gas filling of the reaction chamber, increases the switching rate between etching and deposition processes, and thus improves the substrate etching rate.

However, in the above-mentioned related technologies, in addition to injecting process gas species from the top of the reaction chamber, to ensure a consistent total gas flow rate throughout the process and to facilitate pressure stability, gas species not used in the current process are simultaneously introduced to the lower part of the reaction chamber, thereby indirectly reducing the chamber volume. However, this gas inlet method needs specially designed piping to direct the gas not used in this process to the lower part of the reaction chamber, which will affect the gas flow field inside the reaction chamber. Furthermore, this method will cause the process gas to be constantly mixed with the gas not used in this process, and will negatively impact the process results.

To make the above-mentioned objectives, features, and advantages of the present disclosure more apparent and understandable, specific embodiments of the present disclosure will be described in detail below with reference to the accompanying drawings.

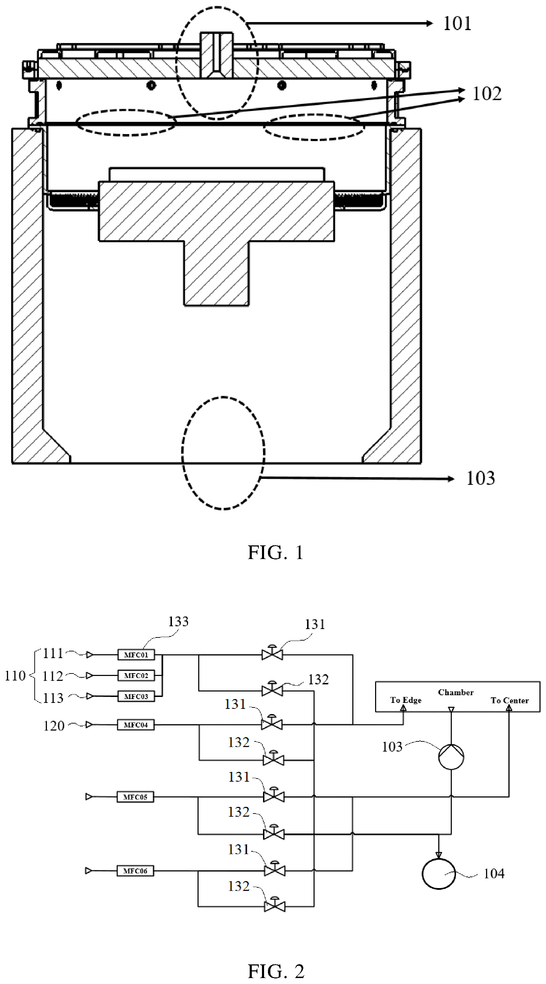

FIG. 1 is a schematic diagram of a process chamber of the semiconductor process equipment to which the gas inlet control method provided in an embodiment of the present disclosure is applied; FIG. 2 is a schematic diagram of a gas supply system of the semiconductor process equipment to which the gas inlet control method provided in an embodiment of the present disclosure is applied; as shown in FIGs. 1 and 2, the semiconductor process equipment includes a process chamber, the process chamber having a central gas inlet 101 located at the center of the top of the process chamber and connected to a central gas inlet pipe, and an edge gas inlet 102 located on the sidewall of the process chamber and connected to an edge gas inlet pipe. The gas supply system of the semiconductor process equipment includes a first pipeline set 110 and a second pipeline set 120. The first pipeline set 110 includes a first branch line 111 for supplying SF₆, a second branch line 112 for supplying NF₃, and a third branch line 113 for supplying O₂. Each branch line is provided with a corresponding mass flow meter 133. That is, the first branch line 111 is provided with an MFC01; the second branch line 112 is provided with an MFC02; and the third branch line 113 is provided with an MFC03. The first branch line 111, the second branch line 112, and the third branch line 113 converge and are all connected to the upstream end of a first switching valve 131 and a second switching valve 132. The downstream end of the first switching valve 131 is connected to the edge inlet pipeline (i.e., To Edge in FIG. 2). The downstream end of the second switching valve 132 is connected to a vacuum pump 104. When the second switching valve 132 is open, the vacuum pump 104 can remove the gas supplied by the first branch line 111, the second branch line 112, and the third branch line 113. The second pipeline set 120 includes a gas line capable of supplying C₄F8 gas. A mass flow meter 133 (MFC04) is also provided on this gas line of the second pipeline set 120. In the second pipeline set 120, one downstream end of the mass flow meter 133 is connected to the edge inlet pipeline (i.e., To Edge in FIG. 2) via another first switching valve 131, and is connected to the vacuum pump 104 via another second switching valve 132.

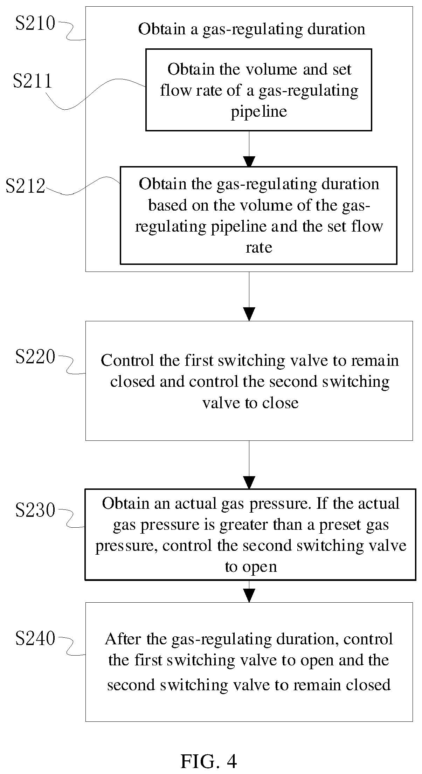

FIG. 4 is a schematic flowchart of a gas inlet control method provided in an embodiment of the present disclosure. As shown in FIG. 4, this gas inlet control method can be applied to the aforementioned semiconductor process equipment. The method includes:
S210, obtain a gas-regulating duration;
Process S210 specifically includes:
   S211, obtain the volume and set flow rate of a gas-regulating pipeline;
   The gas-regulating pipeline refers to the pipeline from the mass flow meter 133 to the first switching valve 131 and the second switching valve 132 in the first branch line 111, the second branch line 112, and the third branch line 113. Correspondingly, the volume of the gas-regulating pipeline refers to the total volume of the internal space of the pipeline between the mass flow meter 133 and the first switching valve 131 and the second switching valve 132. The set flow rate refers to the flow rate controlled by the corresponding mass flow meter 133 when various gas species are flowing. The volume of the gas-regulating pipeline is typically 10 ml to 5 L. Consistent with the present disclosure, the usage duration for each gas is typically 0.1 s to 10 s, correspondingly, the gas-regulating duration is typically less than 5 s.

S212, obtain the gas-regulating duration based on the volume of the gas-regulating pipeline and the set flow rate.

Specifically, the gas-regulating duration can be obtained by dividing the volume of the gas-regulating pipeline by the set flow rate.

Of course, considering that the gas-regulating pressure is higher than the standard gas pressure, process S210 above, i.e., obtaining the gas-regulating duration, further includes:
obtaining the gas-regulating pressure and the standard gas pressure;
the gas-regulating duration is obtained based on the gas-regulating pressure, the standard gas pressure, the volume of the gas-regulating pipeline, and the set flow rate. The gas-regulating duration is positively correlated with the gas-regulating pressure and negatively correlated with the standard gas pressure.

The standard gas pressure is the gas pressure when various gas species are entering into the central or edge inlet pipeline, or after entering the process chamber. The gas-regulating pressure is the highest gas pressure during the gas-regulating process. Since the gas pressure during gas-regulating is higher than the standard gas pressure, it means that the amount of gas entering the gas-regulating pipeline during the gas-regulating process is greater than the amount of gas that normally flows through the gas-regulating pipeline, thus a longer gas-regulating duration is needed. Therefore, the relationship between gas-regulating pressure and standard gas pressure needs to be considered. Gas-regulating pressure is the maximum pressure during the gas-regulating process, not the average pressure. Therefore, gas-regulating duration is positively correlated with gas-regulating pressure and negatively correlated with standard gas pressure, and cannot be calculated by simply dividing the gas-regulating pressure by the standard gas pressure. For example, if the standard gas pressure is 100 mT and the gas-regulating pressure is 200 mT, calculating gas-regulating duration is not simply dividing the volume of the gas-regulating pipeline by the set flow rate and multiplying the result by 2. Instead, a correction factor of 1.5 or 1.6 can be considered to obtain a more reliable gas-regulating duration.

S220, control the first switching valve 131 to remain closed and control the second switching valve 132 to close.

In some embodiments, process S220 specifically includes:
obtaining the moment when gas is introduced into the chamber;
obtaining the gas-regulating start time based on the moment when gas is introduced into the chamber and the gas-regulating duration;
controlling the first switching valve 131 to remain closed and the second switching valve 132 to close at the gas-regulating start time.

Specifically, obtaining the moment when each gas is introduced into the chamber, the gas-regulating duration is calculated backward from that time to obtain the gas-regulating start time, i.e., the moment at which gas-regulating begins. At this moment, the second switching valve 132 is controlled to be switched from the previously open state to the closed state, and the first switching valve 131 is controlled to be closed.

Consistent with the present disclosure, the semiconductor process equipment includes a first pipeline set 110 and a second pipeline set 120. The first pipeline set 110 provides a first gas for performing the deposition process; the second pipeline set 120 provides a second gas for performing the etching process. The first pipeline set 110 and the second pipeline set 120 are respectively provided with a mass flow meter 133, a first switching valve 131, and a second switching valve 132.

Specifically in the Bosch process, deposition and etching processes need alternating gas supply. Since the etching rate is pressure-dependent, higher gas pressure results in a higher etching rate. However, the mixed state of the gas species can reduce wafer throughput. Simultaneously, lower deposition gas pressure leads to more uniform deposition, specifically for protecting the sidewalls of vias, lower gas pressure is needed. Therefore, most often, the process recipe is as shown in Table 1 below, with one low-pressure deposition process and two high-pressure etching processes within a cycle. The deposition process needs gas supply from the first pipeline set 110, and the two etching processes need gas supply from the second pipeline set 120. Therefore, there are two gas supply path switching processes within one cycle.

**Table 1**

| **Process** | **Gas Pressure (mT)** | **Excitation Power (W)** | **Lower Electrode RF Power (W)** | **Standard Gas Flow Rate (sccm)** | **Gas Species** | **Process Duration (s)** | **Gas-regulation Duration (s)** |
|---|---|---|---|---|---|---|---|
| Deposition | 70 | 3000 | 30 | 300 | C₄F₈ | 0.5 | 0 |
| Etching 1 | 140 | 3000 | 200 | 500 | SF₆ | 0.3 | 0.3 |
| Etching 2 | 140 | 3000 | 100 | 500 | SF₆ | 0.5 | 0 |

As can be seen from Table 1 above, there is a pressure rise in the gas pressure in the process chamber when the deposition process is switched to the etching process. Conversely, there is a pressure drop when the etching process is switched to the deposition process. Therefore, when the deposition process is switched to the etching process, gas-regulating is needed in the gas supply pipeline that introduces the gas needed for the etching process into the process chamber, while no gas-regulating is needed when the etching process is switched to the deposition process.

Based on this, throughout the entire deposition process, the first switching valve 131 connected to the first pipeline set 110 is kept open, while the second switching valve 132 connected to the first pipeline set 110 is kept closed to supply the first gas to the process chamber. During the pre-gas-regulating duration of the deposition process (pre-gas-regulating duration = deposition process duration - gas-regulating duration), the first switching valve 131 connected to the second pipeline set 120 is kept closed, while the second switching valve 132 connected to the second pipeline set 120 is kept open to disconnect the second pipeline set 120 from the process chamber and allow the second gas to flow to the vacuum pump 104. At the start time of the gas-regulating of the deposition process, the second switching valve 132 connected to the second pipeline set 120 is controlled to be closed and remain closed until the gas-regulating duration ends, thus achieving gas-regulating during the gas-regulating duration of the deposition process.

The specific method for obtaining the pre-gas-regulating duration of the deposition process is as follows: Process S220 above, i.e., control the first switching valve 131 to remain closed and control the second switching valve 132 to close, further includes:
Obtain the deposition process duration;
Obtain the pre-gas-regulating duration based on the deposition process duration and the gas-regulating duration. The pre-gas-regulating duration is positively correlated with the deposition process duration and negatively correlated with the gas-regulating duration. Specifically, pre-gas-regulating duration = deposition process duration - gas-regulating duration.

During the pre-gas-regulating duration, the first switching valve 131 connected to the first pipeline set 110 remains open, and the second switching valve 132 connected to the first pipeline set 110 remains closed, allowing the first gas for the deposition process to flow into the process chamber. Meanwhile, during the pre-gas-regulating duration, the first switching valve 131 connected to the second pipeline set 120 remains closed, and the connected second switching valve remains open, allowing the second gas for the etching process to flow into the vacuum pump 104.

During the subsequent gas-regulating duration, the states of the first switching valve 131 and the second switching valve 132 connected to the first pipeline set 110 remain unchanged, and the first gas continues to flow to the process chamber. At the start of the gas-regulating duration, the first switching valve 131 connected to the second pipeline set 120 is controlled to be closed and remain closed until the gas-regulating duration ends, while the second switching valve 132 remains closed, and the second gas flows to the gas-regulating pipeline for gas-regulating.

When the gas-regulating duration ends, i.e., when the etching process gas is introduced into the chamber, the first switching valve 131 connected to the first pipeline set 110 is controlled to be closed, and the second switching valve 132 connected to the first pipeline set 110 is controlled to be open, allowing the first gas to flow to the vacuum pump 104 until the deposition process restarts. The first switching valve 131 connected to the second pipeline set 120 then is controlled to be open, and the second switching valve 132 connected to the second pipeline set 120 is controlled to be closed, allowing the second gas to flow to the process chamber until the etching process ends.

Therefore, consistent with the present disclosure, the opening and closing of the first switching valve 131 and the second switching valve 132 in the pipeline set supplying gas to perform a certain process are not synchronized. Not synchronized means that in this pipeline set, one of the first switching valve 131 and the second switching valve 132 is controlled to be opened does not mean the other is controlled to be closed simultaneously. In actual operation, the first switching valve 131 will initially remain closed, while the corresponding second switching valve 132 will be open for a short period during this time, then close again to achieve the needed gas-regulating duration, and then the first switching valve 131 is controlled to be opened again to achieve pressurization.

S230, obtain an actual gas pressure. If the actual gas pressure is greater than a preset gas pressure, control the second switching valve 132 to open.

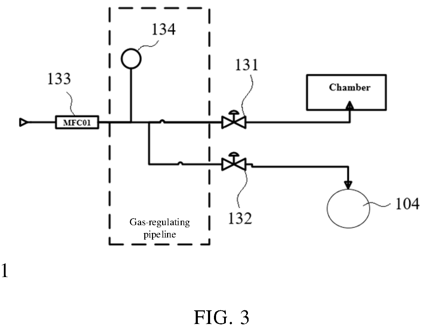

As shown in FIG. 3, specifically, the actual gas pressure refers to the gas pressure in the gas-regulating pipeline. Since both the first switching valve 131 and the second switching valve 132 remain closed during the gas-regulating process, the gas pressure in the gas-regulating pipeline can be considered basically uniform. Specifically, the actual gas pressure can be measured by a vacuum gauge connected to the gas-regulating pipeline. The preset gas pressure is the maximum allowable gas pressure in the gas-regulating pipeline, for example, 1 torr to 760 torr. When the actual gas pressure exceeds the preset gas pressure, the second switching valve 132 can be forcibly opened to allow gas to escape and an alarm can be triggered. Since the vacuum pump 104 and the molecular pump 103 are connected, a pressure of 400 torr at this location will not typically damage the vacuum system. In this design, a gas pressure below 400 torr is configured to supply gas to the process chamber. Without this control process, the pressure in the gas-regulating pipeline will continuously increase with the gas-regulating duration, eventually causing the mass flow meter 133 to fail and creating a risk of backflow. This control method ensures that the downstream end of the mass flow meter 133 is under a safe gas pressure, preventing the mass flow meter 133 from failing.

S240, after the gas-regulating duration, the first switching valve 131 is controlled to be opened and the second switching valve 132 is controlled to remain closed.

At process S240, the start time of the gas-regulating duration is calculated from the moment the first switching valve 131 is controlled to remain closed and the second switching valve 132 is controlled to be closed.

If the actual gas-regulating duration is too long, the gas pressure on both sides of the mass flow meter 133 will be the same, causing the mass flow meter 133 to malfunction. Therefore, during the gas-regulating duration, the gas pressure continuously increases. When the gas-regulating duration is reached, i.e., after the gas-regulating duration has elapsed, the first switching valve 131 is controlled to be opened and the second switching valve 132 is controlled to be closed. The gas with higher pressure in the gas-regulating pipeline, i.e., the gas with a larger amount of substance, can then enter the edge inlet pipeline. Therefore, at the beginning of the process, the actual inlet flow rate is greater than the set flow rate of the mass flow meter 133. For example, consistent with the present disclosure, a 0.3 s gas-regulating duration is performed, which can instantly increase the pressure rise rate of the process chamber by two times, significantly higher than conventional methods. In conventional methods, the typical gas inlet rate is 20sccm~3000sccm, preferably 100sccm~600sccm. Therefore, the present disclosure adopts the above-mentioned gas inlet control method, which can complete gas switching more quickly. If multiple mixed gas species are used alternately in the process, this process can achieve rapid gas switching.

In summary, the present disclosure employs the aforementioned method of closing the second switching valve during the gas-regulating duration before the process gas is introduced into the chamber (i.e., at the start of gas-regulating), continuously supplying the process gas into the gas-regulating pipeline, thus creating a gas-regulating phenomenon and effectively increasing the gas pressure in the gas-regulating pipeline. Since the gas flow rate through a certain section of pipeline or region is positively correlated with the pressure difference between the inlet and outlet of that section or region, the gas pressure in the gas-regulating pipeline is increased, significantly increasing the rate at which the process gas is introduced into the process chamber through the first switching valve. In other words, for gas with the same amount of substance, the gas inlet time can be shortened, thereby improving gas inlet efficiency.

Furthermore, since the second switching valve is controlled to be closed before the gas is introduced into the chamber, unlike related technologies where some of the introduced gas is pumped away, the process gas introduced before the gas introduction time can enter the process chamber without being directly pumped away, thus saving on process gas consumption. Furthermore, if the gas pressure in the process chamber differs during different process stages, and the gas pressure in a later process is higher than that in a previous process, gas-regulating gas in the gas-regulating pipeline can increase the gas pressure in the gas-regulating pipeline. This facilitates reaching the needed gas pressure in the process chamber earlier during the gas inlet process, thus shortening the moment for the process chamber to reach that pressure.

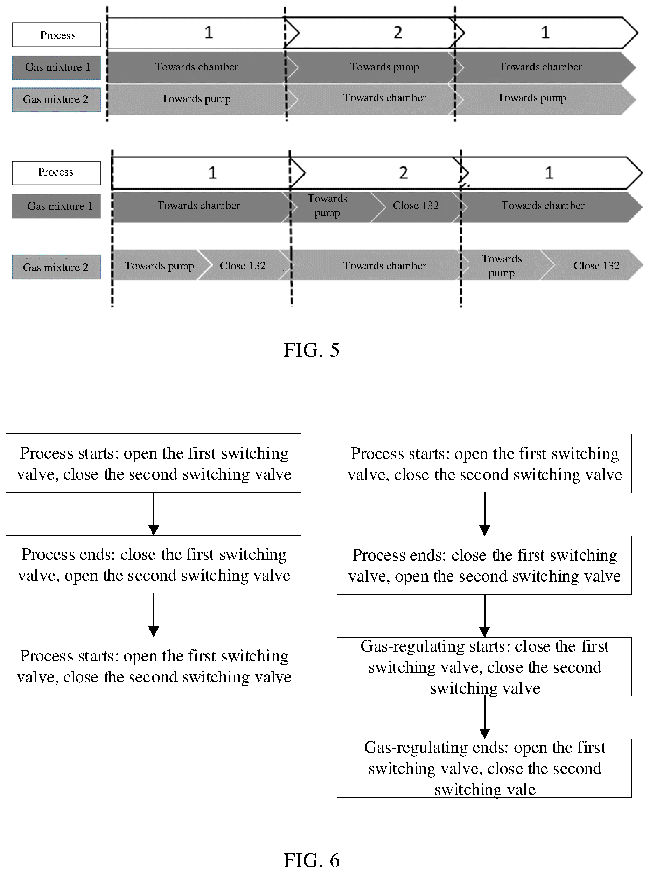

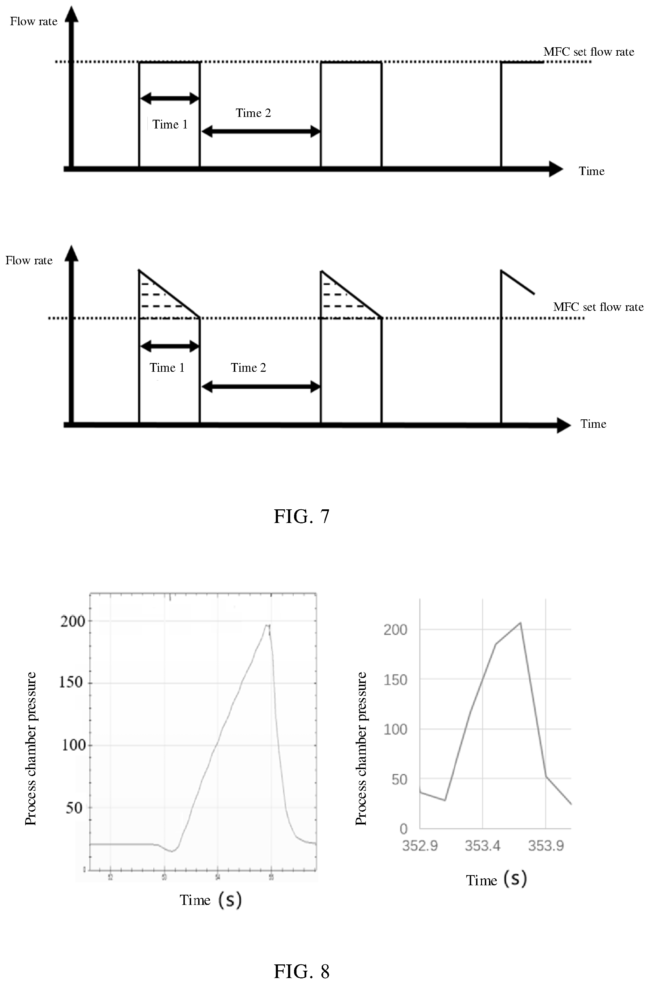

Furthermore, FIG. 5 is a comparative schematic diagram of gas state switching between related technology 1 and the embodiment of the present disclosure. The upper half of the figure represents related technology 1, and the lower half represents the embodiment of the present disclosure. FIG. 6 is a schematic flowchart of the control process of the first switching valve 131 and the second switching valve 132 in related technology 1 and the embodiment of the present disclosure. The left half of the figure represents related technology 1, and the right half represents the embodiment of the present disclosure. FIG. 7 is a comparative timing schematic diagram of the flow rate of gas entering the process chamber from a certain edge inlet pipeline in related technology 1 and the embodiment of the present disclosure. The upper half of the figure represents related technology 1, and the lower half represents the embodiment of the present disclosure. FIG. 8 is a schematic diagram showing the pressure change within the process chamber when gas is introduced into the process chamber through an edge inlet pipeline in both related technology 1 and the embodiment of the present disclosure. The left half of the figure represents Related Technology 1, and the right half represents the embodiment of the present disclosure.

In the solution of Related Technology 1, at time 2 in FIG. 7, the gas passing through the mass flow meter 133 at a set flow rate does not enter the process chamber to participate in the process, but is pumped away by the vacuum pump 104, resulting in gas waste. In the embodiment of the present disclosure, however, some or all of the gas that would otherwise be pumped away by the vacuum pump 104 is stored between the mass flow meter 133 and the first switching valve 131. At the start of the process, the gas is rapidly introduced into the process chamber to participate in the process. Therefore, this method can save process gas, i.e., uses a smaller flow rate to complete the gas switching.

When a large pressure difference exists between processes, such as a pressure difference of more than 30 mT between the high-pressure process and the process with the lowest pressure, this gas inlet method increases the pressure in the gas-regulating pipeline. This allows for a pressure increase in the upstream end of the first switching valve 131 that needs to introduce gas into the process chamber at the beginning of process. This accelerates the gas inlet rate, quickly completes gas switching within the process chamber, and increases the pressure, preventing the two gas species from mixing in the process chamber for an extended period, thus improving process performance. As shown in FIG. 5, during each "towards the chamber" process to the right of "close 132" (i.e., close the second switching valve 132), the aforementioned gas inlet enhancement phase accelerating the gas inlet rate will occur. That is, after the second switching valve 132 is closed and then the first switching valve 131 is opened, gas switching within the process chamber is completed more quickly. The duration of the gas inlet enhancement phase can be the entire duration of gas inlet into the process chamber or the initial period of gas inlet into the process chamber. The entire duration is shown in the lower half of FIG. 7 with a triangle filled with dashed lines.

For example, at the start of the deposition process, the duration of this process and the gas-regulating duration for the next process are read. At the beginning of the gas-regulating duration before the end of the deposition process, the second switching valve 132 for the gas needed for the next process is controlled to be closed, gas-regulating the gas needed for the next process. This allows for a faster pressure rise rate when the process chamber needs higher pressure at the start of the next process. As shown in FIG. 8, the left figure shows the ultimate pressure rise curve when SF₆ with a gas flow rate of 500 sccm is introduced without using this control method. With the first switching valve 131 open and the gas entering the process chamber for 1.4 s, a pressure rise of 158 mT can be achieved. The right figure shows the ultimate pressure rise curve when using the control method with the gas-regulating function. With SF₆ with a gas flow rate of 500 sccm, a pressure rise of 150 mT can be achieved with the first switching valve 131 open and the gas entering the process chamber for 0.5 s. The pressure rise rate is nearly three times that without using the control method. This results in higher etching rates and wafer throughput. In Table 1 above, when transitioning from the etching process 2 to the deposition process, since a significant pressure increase is not needed, the existing gas inlet method can be used. In practical applications, the process recipe is not limited to the three processes and two gas inlet states shown in Table 1.

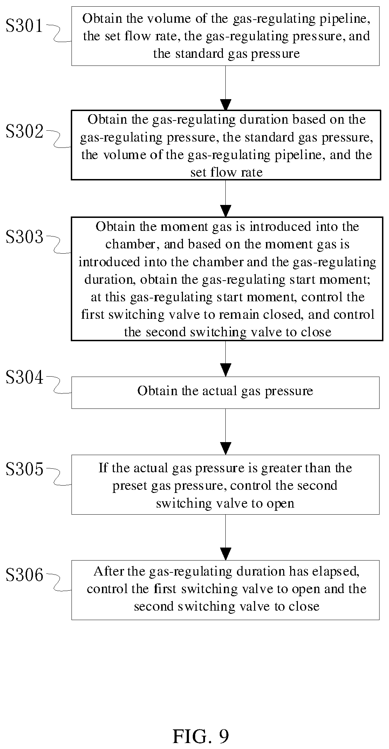

FIG. 9 is a schematic flowchart of another gas inlet control method in an embodiment of the present disclosure. The method includes:
S301, obtain the volume of the gas-regulating pipeline, the set flow rate, the gas-regulating pressure, and the standard gas pressure.
S302, obtain the gas-regulating duration based on the gas-regulating pressure, the standard gas pressure, the volume of the gas-regulating pipeline, and the set flow rate.
S303, obtain the moment gas is introduced into the chamber, and based on the moment gas is introduced into the chamber and the gas-regulating duration, obtain the gas-regulating start moment; at this gas-regulating start moment, control the first switching valve 131 to remain closed, and control the second switching valve 132 to close.
S304, obtain the actual gas pressure;
S305, if the actual gas pressure is greater than the preset gas pressure, control the second switching valve 132 to open;
S306, after the gas-regulating duration has elapsed, control the first switching valve 131 to open and the second switching valve 132 to close.

The present disclosure also provides a gas supply system applied to semiconductor process equipment. The semiconductor process equipment includes a process chamber. The gas supply system is configured to execute the above-described gas inlet control method. The gas supply system includes: a gas supply path, each gas supply path... Each gas supply path is independently connected to the process chamber via a first switching valve 131;

A vacuum pump 104 is used, with each gas supply path independently connected to the vacuum pump 104 via a second switching valve 132;

A mass flow meter 133 is configured to connect the gas supply path to the first switching valve 131 and the second switching valve 132;

A check valve control assembly is configured to prevent the gas pressure on the side of the mass flow meter 133 facing the first switching valve 131 and the second switching valve 132 from being higher than the pressure on the side of the mass flow meter 133 facing the gas supply path.

Specifically, in the semiconductor process equipment consistent with the present disclosure, the upstream of the molecular pump 102 is connected to the process chamber, and the downstream of the molecular pump 102 is connected to the vacuum pump 104, allowing the molecular pump 102 to extract gas from the process chamber and discharge it through the vacuum pump 104.

Consistent with the present disclosure, the gas supply path is independently connected to the process chamber via a first switching valve 131. This means that the gas needed for each process is connected to the process chamber via a first switching valve 131. For example, the gas introduced into the process chamber during the etching process is connected to the process chamber via one first switching valve 131, while the gas introduced into the process chamber during the deposition process is connected to the process chamber via another first switching valve 131. It is important to note that "connected to the process chamber via the first switching valve 131" does not mean that the outlet of the first switching valve 131 is directly connected to the process chamber. Instead, the first switching valve 131 is connected to the process chamber via an inlet pipeline. This inlet pipeline may include a central inlet pipeline leading to the top of the process chamber and edge inlet pipelines leading to the side walls of the process chamber.

By providing a check valve control assembly, when the gas supply pipeline is gas-regulating, the gas in the gas-regulating pipeline between the first switching valve 131 and the second switching valve 132 can be released if the gas-regulating pressure becomes excessive. This eliminates the risk of mass flow meter failure or even gas backflow caused by excessively high gas pressure in the gas-regulating pipeline between mass flow meter 133 and the first switching valve 131 and the second switching valve 132 due to prolonged gas-regulating duration.

In some embodiments, as shown in FIG. 3, the check valve control assembly includes a vacuum gauge 134 configured to measure the gas pressure in the pipeline between mass flow meter 133 and the first switching valve 131 or between mass flow meter 133 and the second switching valve 132.

Specifically, consistent with the present disclosure, the range of the vacuum gauge 134 can be selected from 1 torr to 760 torr. Since the process chamber in the semiconductor process equipment used in the present disclosure is connected to the molecular pump 102, and the molecular pump 102 is connected to the vacuum pump 104, and the gas-regulating pressure in the present disclosure is less than 400 torr, this pressure will not damage the vacuum system.

By providing the vacuum gauge 134, the pressure in the gas-regulating pipeline between the first switching valve 131 and the second switching valve 132 can be obtained. When the pressure exceeds the preset pressure, the relevant valves can be controlled to operate, thereby protecting the mass flow meter 133.

In some embodiments, the check valve control assembly further includes a one-way valve (not shown in the figure) located between the vacuum pump 104 and the mass flow meter 133; the one-way valve is configured to allow only unidirectional flow from the mass flow meter 133 to the vacuum pump 104.

By providing a one-way valve, the gas entering the inlet of the vacuum pump 104 can be prevented from flowing backward to the downstream end of the mass flow meter 133. This prevents the gas discharged from the process chamber in the previous process from flowing back into the process chamber through the first switching valve 131 during operation of the gas supply system, thus ensuring the reliability of the process operation.

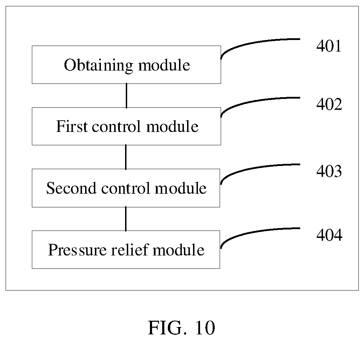

FIG. 10 is a schematic diagram of the controller in a gas supply system according to an embodiment of the present disclosure.

As shown in FIG. 10, the gas supply system further includes a controller, and the controller includes:
an obtaining module 401 configured to obtain the gas-regulating duration;
a first control module 402 configured to control the first switching valve 131 to remain closed and controlling the second switching valve 132 to close. The first switching valve 131 is connected between the mass flow meter 133 and the gas supply pipeline of the process chamber, and the second switching valve 132 is connected between the mass flow meter 133 and the vacuum pump 104;
a second control module 403, after the gas-regulating duration has elapsed, controls the first switching valve 131 to open and the second switching valve 132 to close.

As one embodiment, the obtaining module 401 is specifically configured to: obtain the volume and set flow rate of the gas-regulating pipeline, and obtain the gas-regulating duration based on the volume and set flow rate of the gas-regulating pipeline.

As one embodiment, the obtaining module 401 is further specifically configured to: obtain the gas-regulating pressure and standard gas pressure, and obtain the gas-regulating duration based on the gas-regulating pressure, standard gas pressure, volume and set flow rate of the gas-regulating pipeline. The gas-regulating duration is positively correlated with the gas-regulating pressure and negatively correlated with the standard gas pressure.

As one embodiment, the controller further includes a pressure relief module 404 specifically configured to: obtain the actual gas pressure; if the actual gas pressure is greater than the preset gas pressure, control the second switching valve 132 to open.

As one embodiment, the second control module 403 is further specifically configured to: obtain the moment when gas is introduced into the chamber; obtain the gas-regulating start time based on the gas introduction time and the gas-regulating duration; at the gas-regulating start time, control the first switching valve 131 to remain closed and control the second switching valve 132 to close.

As one embodiment, the second control module 403 is further specifically configured to control the first switching valve 131 to remain closed and to control the second switching valve 132 to close, including:
obtaining the process duration of the deposition process; obtaining the pre-gas-regulating duration based on the deposition process duration and the gas-regulating duration. The pre-gas-regulating duration is positively correlated with the deposition process duration and negatively correlated with the gas-regulating duration;
controlling the second switching valve 132 to close after the pre-gas-regulating duration has elapsed since the start of the deposition process.

The present disclosure also provides semiconductor process equipment, including the above-described gas supply system.

By providing the above-described gas supply system in the semiconductor process equipment, the semiconductor process equipment correspondingly possesses all the advantages of the above-described gas supply system, and that will not be elaborated further here.

Although the present disclosure discloses the above, the present disclosure is not limited thereto. Any person skilled in the art can make various modifications and alterations without departing from the spirit and scope of the present disclosure; therefore, the scope of protection of the present disclosure should be determined by the scope defined in the claims.

Finally, it should be noted that in this document, relational terms such as "first" and "second" are used only to distinguish one entity or operation from another, and do not necessarily need or imply any such actual relationship or order between these entities or operations. Furthermore, the terms "comprising," "including," or any other variations thereof are intended to cover non-exclusive inclusion, such that a process, method, article, or apparatus that comprises a list of elements includes not only those elements but also other elements not expressly listed, or elements inherent to such a process, method, article, or apparatus. Without further limitations, an element defined by the phrase "comprising one..." does not exclude the presence of other identical elements in the process, method, article, or apparatus that includes said element.

The various embodiments in this specification are described in a progressive manner, with each embodiment focusing on the differences from other embodiments. Similar or identical parts between embodiments can be referred to interchangeably. For the gas supply system and semiconductor process equipment disclosed in the embodiments, since they correspond to the gas inlet control method disclosed in the above embodiments, the description is relatively simple, and relevant parts can be referred to in the method section.

Although the present disclosure has been disclosed above, the present disclosure is not limited thereto. Any person skilled in the art can make various modifications and alterations without departing from the spirit and scope of the present disclosure; therefore, the scope of protection of the present disclosure should be determined by the scope defined in the claims.

## Claims

1. A gas inlet control method, applied to semiconductor process equipment, comprising:
obtaining a gas-regulating duration;
controlling a first switching valve to remain closed and controlling a second switching valve to close, the first switching valve being connected between a mass flow meter and a gas supply pipeline of a process chamber, and the second switching valve being connected between the mass flow meter and a vacuum pump;
after the gas-regulating duration has elapsed, controlling the first switching valve to open and controlling the second switching valve to remain closed.

2. The gas inlet control method according to claim 1, wherein obtaining the gas-regulating duration includes:
obtaining a volume of a gas-regulating pipeline and a set flow rate;
obtaining the gas-regulating duration based on the volume of the gas-regulating pipeline and the set flow rate.

3. The gas inlet control method according to claim 2, wherein obtaining the gas-regulating duration further includes:
obtaining a gas-regulating pressure and a standard gas pressure;
obtaining the gas-regulating duration based on the gas-regulating pressure, the standard gas pressure, the volume of the gas-regulating pipeline, and the set flow rate, the gas-regulating duration being positively correlated with the gas-regulating pressure and negatively correlated with the standard gas pressure.

4. The gas inlet control method according to claim 1, wherein the gas inlet control method further includes:
obtaining an actual gas pressure; if the actual gas pressure is greater than a preset gas pressure, controlling the second switching valve to open.

5. The gas inlet control method according to claim 1, wherein controlling the first switching valve to remain closed and controlling the second switching valve to close includes:
obtaining a moment when gas is introduced into the chamber;
obtaining a gas-regulating start time based on the moment when gas is introduced into the chamber and the gas-regulating duration;
controlling the first switching valve to remain closed and controlling the second switching valve to close at the gas-regulating start time.

6. The gas inlet control method according to claim 1, wherein the semiconductor process equipment includes a first pipeline set and a second pipeline set, the first pipeline set being configured to provide a first gas for performing a deposition process, the second pipeline set being configured to provide a second gas for performing an etching process, the first pipeline set and the second pipeline set are respectively provided with the mass flow meter, the first switching valve, and the second switching valve;
during the entire deposition process, the first switching valve connected to the first pipeline set is controlled to remain open, and the second switching valve connected to the first pipeline set is controlled to remain closed, so as to provide the first gas to the process chamber;
during a pre-gas-regulating duration of the deposition process, the first switching valve connected to the second pipeline set is controlled to remain closed, and the second switching valve connected to the second pipeline set is controlled to remain open, so as to disconnect the second pipeline set from the process chamber and allow the second gas to flow to the vacuum pump;
at the gas-regulating start time of the deposition process, the second switching valve connected to the second pipeline set is controlled to close and remain closed until the gas-regulating duration ends.

7. The gas inlet control method according to claim 6, wherein controlling the first switching valve to remain closed and controlling the second switching valve to close further includes:
obtaining a process duration of the deposition process preceding the etching process that needs gas-regulating;
obtaining the pre-gas-regulating duration based on the process duration and the gas-regulating duration, the pre-gas-regulating duration being positively correlated with the process duration and negatively correlated with the gas-regulating duration.

8. A gas supply system applied to the semiconductor process equipment including a process chamber, wherein the gas supply system is configured to execute the gas inlet control method of any one of claims 1-7, the gas supply system comprising:
a gas supply path, each of the gas supply paths being independently connected to the process chamber via the first switching valve;
the vacuum pump, each of the gas supply paths being independently connected to the vacuum pump via the second switching valve;
the mass flow meter, the gas supply path being connected to the first switching valve and the second switching valve via the mass flow meter; and
a check valve control assembly, configured to prevent a gas pressure on a side of the mass flow meter facing the first switching valve and the second switching valve from being greater than a pressure on a side of the mass flow meter facing the gas supply path.

9. The gas supply system according to claim 8, wherein the check valve control assembly includes a vacuum gauge configured to measure the gas pressure in a pipeline between the mass flow meter and the first switching valve or between the mass flow meter and the second switching valve.

10. The gas supply system according to claim 8, wherein the check valve control assembly further includes a one-way valve disposed between the vacuum pump and the mass flow meter, the one-way valve being configured to allow only unidirectional flow from the mass flow meter to the vacuum pump.

11. The gas supply system according to claim 8, further comprising a controller, the controller including:
an obtaining module configured to obtain the gas-regulating duration;
a first control module configured to control the first switching valve to remain closed and control the second switching valve to close, the first switching valve being connected between the mass flow meter and the gas supply pipeline of the process chamber, the second switching valve being connected between the mass flow meter and the vacuum pump; and
a second control module configured to control the first switching valve to open and the second switching valve to close after the gas-regulating duration has elapsed.

12. Semiconductor process equipment, comprising the gas supply system according to any one of claims 8-11.
